Europäisches Patentamt

European Patent Office

Office européen des brevets

(11) Veröffentlichungsnummer: **0 500 994 A1**

# EUROPÄISCHE PATENTANMELDUNG

(21) Anmeldenummer: **91103031.0**

(51) Int. Cl.5: **H05K 9/00**, H01R 4/64

(22) Anmeldetag: **28.02.91**

(43) Veröffentlichungstag der Anmeldung:
**02.09.92 Patentblatt 92/36**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Bredow, Reinhard, Dipl.-Ing.**
**Obere Lagerstrasse 9**
**W-8039 Puchheim(DE)**
Erfinder: **Mair, Eduard**
**Allgäuer Strasse 79**
**W-8000 München 71(DE)**
Erfinder: **Sedlmeier, Peter, Dipl.-Ing. (FH)**
**Triester Strasse 23**
**W-8000 München 80(DE)**

(54) **Kontaktfederstreifen zum elektromagnetischen Abdichten von Gehäuseteilen eines Schirmgehäuses.**

(57) Die Breite von Federzungen (5) eines Kontaktfederstreifens (1) variiert in unregelmäßiger Verteilung. Dadurch wird eine gute Schirmwirkung über ein breites Frequenzspektrum erzielt.

EP 0 500 994 A1

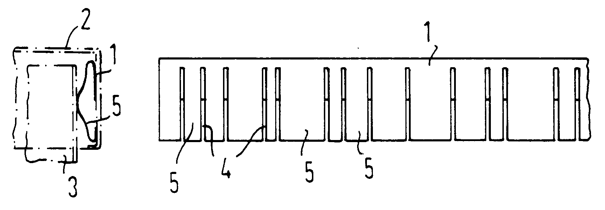

Die Erfindung bezieht sich auf einen Kontaktfederstreifen zum elektromagnetischen Abdichten von Gehäuseteilen eines Schirmgehäuses, wobei der gefiederte Kontaktfederstreifen freigestanzte querstehende Federzungen aufweist und mit jeweils zwei der Gehäuseteile kontaktierbar ist. Ein derartiger Kontaktfederstreifen ist z. B. durch die Firmenschrift "Aufbausysteme Intermas, HF-gedichteter Baugruppenträger" der Firma AEG, Aktiengesellschaft Frankfurt bekannt geworden. Nach Bild 5 verspannt sich z. B. der Kontaktfederstreifen zwischen einer Gehäuseseitenwand und einer rückwärtigen Haube. Der Kontaktfederstreifen wird als lamellierte Edelstahlfeder beschrieben, die alle 10 mm einen definierten Kontakt herstellt. Die Teilungsabstände werden üblicherweise so gewählt, daß die am stärksten auftretenden Frequenzen besonders gut geschirmt werden.

Der Erfindung liegt die Aufgabe zugrunde, eine gute Schirmwirkung auch bei unterschiedlichen Frequenzen zu ermöglichen.

Diese Aufgabe wird durch die Erfindung gemäß Anspruch 1 gelöst. Die unterschiedlich breiten Kontaktfederstreifen verhindern das Auftreten von Resonanzen im Bereich der Trennfugen zwischen den zu dichtenden Gehäuseteilen. Regelmäßig verteilte Federzungen würden bei längeren zu verbindenden Fugen diskreten Frequenzen die Möglichkeit bieten, durch die zwischen den Federzungen angeordneten Schlitze hindurchzutreten. Durch die unterschiedlichen Teilungsbreiten wird das gesamte Frequenzspektrum gleichmäßig gedämpft. Der erfindungsgemäße Kontaktfederstreifen hat weiterhin den Vorteil, daß er universell auch für engere Frequenzspektren einsetzbar ist, die sonst Kontaktfederstreifen von unterschiedlicher Teilung erfordern würden. Im einfachsten Fall weist der Kontaktfederstreifen zwei unterschiedliche Breiten der Federzungen auf, die sich einander abwechseln. Bereits dadurch wird die Schirmdämpfung erheblich erhöht. Eine größere Anzahl unterschiedlicher Breiten verbessert die Schirmwirkung noch weiter.

Durch die unregelmäßige Verteilung der Federbreiten nach Anspruch 2 wird die Schirmwirkung noch mehr verbessert. Dabei können die Schlitze zwischen dem Kontaktfederstreifen z. B. in einer Presse gestanzt werden, die einen Bandvorschub aufweist, der von einem Schrittmotor angetrieben ist. Dieser kann durch einen Zufallsgenerator so gesteuert werden, daß eine völlig unregelmäßige Verteilung der Federzungen erzeugt wird.

Die Weiterbildung nach Anspruch 3 läßt sich besonders vorteilhaft z. B. dadurch realisieren, daß eine Gruppe von unterschiedlich verteilten Schnittstempeln in einem Werkzeug angeordnet wird, die in einem Arbeitsgang die unterschiedlich breiten Federzungen erzeugen. Die Wiederholung des Stanzbildes in der nächsten Gruppe führt zu keiner nennenswerten Beeinträchtigung der Schirmwirkung.

Die Weiterbildung nach Anspruch 4 ergibt Federzungen von hinreichender Federkraft und hinreichender Anpassungsfähigkeit an Abweichungen der Gehäuseabmessungen.

Im folgenden wird die Erfindung anhand eines in der Zeichnung dargestellten Ausführungsbeispiels näher erläutert.

Die dargestellte Figur zeigt einen Kontaktfederstreifen 1 im Profil und in einer Draufsicht mit einem strichpunktiert angedeuteten Deckel 2 und einem Gehäuseteil 3 eines Baugruppenträgers. Der Kontaktfederstreifen 1 weist in sich zurückgebogene Enden und in seinem mittleren Bereich eine Ausbauchung auf. Er ist von einem Ende her mit Querschlitzen 4 versehen, zwischen denen unterschiedlich breite Federzungen 5 ausgebildet sind. Diese sind zwischen 2 und 12 mm breit und unregelmäßig verteilt angeordnet.

Bezugszeichenliste

| 1 | Kontaktfederstreifen |
|---|---|
| 2 | Deckel |
| 3 | Gehäuseteil |
| 4 | Schlitz |
| 5 | Federzunge |

**Patentansprüche**

1. Kontaktfederstreifen (1) zum elektromagnetischen Abdichten von Gehäuseteilen (z. B. 2, 3) eines Schirmgehäuses, wobei der gefiederte Kontaktfederstreifen (1) freigeschnittene querstehende Federzungen (5) aufweist und mit jeweils zwei der Gehäuseteile kontaktierbar ist, **dadurch gekennzeichnet,** daß die Federzungen (5) entlang dem Kontaktfederstreifen unterschiedlich breit ausgebildet sind.

2. Kontaktfederstreifen nach Anspruch 1, **dadurch gekennzeichnet,** daß die unterschiedlich breiten Federzungen (5) unregelmäßig verteilt angeordnet sind.

3. Kontaktfederstreifen nach Anspruch 1 oder 2, **dadurch gekennzeichnet,** daß aufeinanderfolgende Gruppen von Federzungen (5) eine stets gleiche, in sich unregelmäßige Verteilung der unterschiedlich breiten Federzungen (5) aufweisen.

4. Kontaktfederstreifen nach Anspruch 1, 2 oder 3, **dadurch gekennzeichnet,** daß die Breite der Federzungen (5) zwischen 2

**EP 0 500 994 A1**

und 12 mm variiert.

Europäisches
Patentamt

**EUROPÄISCHER RECHERCHENBERICHT**

Nummer der Anmeldung

EP    91 10 3031

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-U-7 009 197 (F. HELLIGE & CO. GMBH.)<br>* Seite 2, Zeile 5 - Zeile 13; Abbildung 3 *<br>--- | 1 | H05K9/00<br>H01R4/64 |
| A | US-A-4 140 870 (VOLKERS ET AL.)<br>* Anspruch 7; Abbildung 7 *<br><br>----- | 1 | |
| | | | **RECHERCHIERTE SACHGEBIETE (Int. Cl.5)**<br><br>H05K<br>H01R |

Der vorliegende Recherchenbericht wurde für alle Patentansprüche erstellt

| Recherchenort | Abschlußdatum der Recherche | Prüfer |
|---|---|---|
| DEN HAAG | 21 OKTOBER 1991 | HORAK A.L. |